# FASCICULE DE BREVET EUROPEEN

(11) **EP 3 052 909 B1**
(45) Date de publication et mention de la délivrance du brevet: **09.11.2022**
(21) Numéro de dépôt: 14796209.6
(22) Date de dépôt: 29.09.2014
(51) Int. Cl.: G01J 5/06, H05K 1/18

(54) **CIRCUIT IMPRIME FLEXIBLE A FAIBLE EMISSIVITE**
FLEXIBLE BESTÜCKTE LEITERPLATTE MIT GERINGER EMISSIVITÄT
FLEXIBLE PRINTED CIRCUIT WITH LOW EMISSIVITY

(30) Priorité: 02.10.2013 FR 1302295
(43) Date de publication de la demande: 10.08.2016
(73) Titulaire: LYNRED, 91120 Palaiseau (FR)
(72) Inventeur: ROBERT, David, F-38250 Saint Nizier du Moucherotte (FR); ROYER, Yves, F-38470 Vinay (FR)
(74) Mandataire: Talbot, Alexandre
(86) Numéro de dépôt international: PCT/FR2014/052448
(87) Numéro de publication internationale: WO 2015/049448

(56) Documents cités:
- WO-A1-2012/147870
- US-A- 4 118 947
- US-A- 4 926 007
- US-A1- 2011 024 162

## Description

### Domaine technique de l'invention

L'invention est relative à un circuit imprimé flexible à faible émissivité et à son utilisation dans un détecteur infrarouge refroidi.

### État de la technique

Un photodétecteur infrarouge absorbe des photons infrarouges et les convertit en un signal électrique. Il comprend classiquement une matrice d'éléments photosensibles, tels que des photodiodes, des puits quantiques ou des points quantiques. Le matériau de détection, qui forme les éléments photosensibles, est par exemple un alliage de tellure, mercure et cadmium (HgCgTe).

Dans le domaine du rayonnement infrarouge (longueur d'onde variant de 0,7 µm à 14 µm), les photons à détecter ont une énergie comparable au bruit thermique du matériau de détection, lorsque celui-ci fonctionne à température ambiante. Ainsi, pour qu'il ne s'éblouisse pas lui-même, le détecteur est refroidi à une température comprise entre 50 K et 200 K. Le bloc de détection est couplé thermiquement à un cryostat contenant, selon la température d'utilisation, de l'azote liquide, de l'hélium liquide ou un dispositif cryogénérateur.

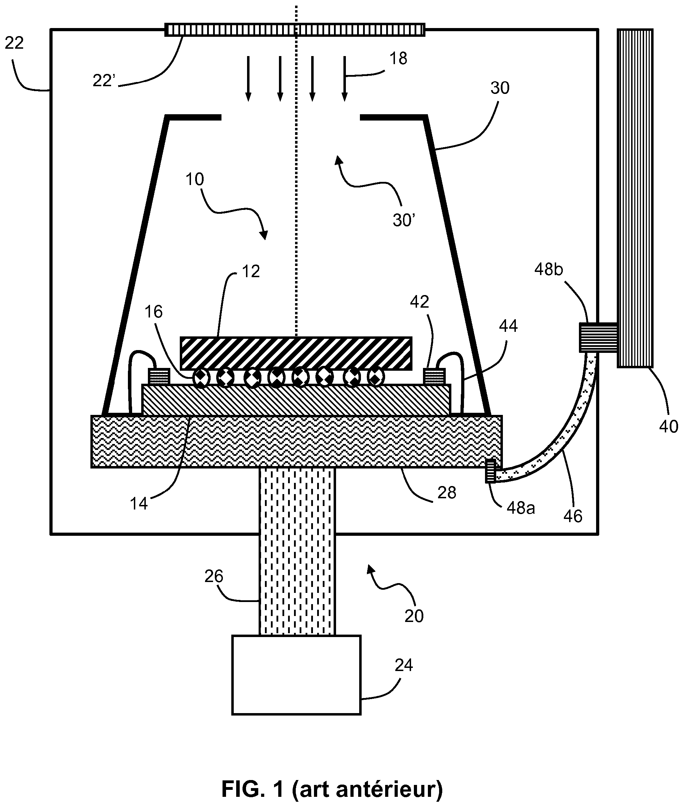

La figure 1 représente schématiquement un exemple classique de détecteur infrarouge muni d'un bloc de détection 10 et de son cryostat 20.

Le détecteur infrarouge comprend un circuit de détection 12 formé d'un substrat en HgCgTe et contenant une matrice de photodiodes. Le circuit de détection 12 est couplé à un circuit de lecture 14 formé d'un substrat en silicium. Le circuit 14 permet de lire et d'amplifier les signaux générés par les photodiodes du circuit de détection.

Le circuit de détection 12 est classiquement hybridé sur le circuit de lecture 14, de manière à former un ensemble monobloc et à faciliter la connexion électrique entre ces deux circuits. Pour cela, la face avant du circuit de détection 12 est connectée à la face avant du circuit de lecture 14, au moyen de microbilles d'indium 16. Un rayonnement infrarouge, symbolisé par les flèches 18 sur la figure 1, atteint les photodiodes par la face arrière du circuit de détection 12.

Le bloc de détection 10, composé des circuits 12, 14 et des microbilles 16, est placé dans le cryostat 20. Ce dernier comprend un boîtier hermétique 22, une source froide 24 et un doigt froid 26 permettant l'échange thermique entre la source froide et le bloc de détection.

Le boîtier 22 définit un volume étanche, dans lequel est placé le bloc de détection 10. Il est pourvu d'un hublot 22' transparent aux rayons infrarouges 18, situé au-dessus du circuit de détection 12 et parallèlement à celui-ci.

Le doigt froid 26 est, à son extrémité inférieure, en contact thermique avec la source froide 24. A son extrémité supérieure, il est surmonté d'un plan froid 28, ou table froide, disposé perpendiculairement au doigt froid 26. Ce plan froid sert de support mécanique au bloc de détection 10. Il est réalisé en un matériau bon conducteur thermique, par exemple en alumine.

Ainsi, le bloc de détection 10 est en liaison thermique avec la source froide 24, par l'intermédiaire du doigt froid 26 et du plan froid 28.

Le détecteur est en outre équipé d'un écran froid 30, percé d'une fenêtre 30' jouant le rôle de diaphragme. Cette fenêtre 30' détermine l'angle sous lequel le circuit de détection 12 voit le rayonnement infrarouge incident 18. L'écran froid 30 absorbe les rayonnements parasites issus des parois chaudes du cryostat et les réflexions indésirables du rayonnement utile 18. L'écran froid est solidarisé mécaniquement et thermiquement au plan froid 28.

Une carte électronique 40, dite de proximité, est située à l'extérieur du cryostat 20. Cette carte génère les signaux nécessaires au pilotage du circuit de détection 12 et numérise les signaux issus du détecteur, à l'aide de convertisseurs analogique-numérique.

La connexion électrique entre le circuit de lecture 14 et la carte de proximité 40 est assurée par des plots de contact 42 sur le circuit de lecture, des fils de soudure 44, puis des pistes métalliques dans la table froide 28 en alumine, et enfin un circuit imprimé flexible 46. Le circuit imprimé flexible 46 est, d'une part, fixé à la table froide 28 par un premier connecteur électrique 48a, et d'autre part, fixé à une paroi du boîtier 22 et à la carte électronique 40 par un second connecteur électrique 48b.

La température du détecteur infrarouge influe directement sur ses performances, notamment le courant d'obscurité. Pour des performances de détection élevées, il convient de maintenir constante la température du plan focal, autrement dit, la température du circuit de détection.

Afin de limiter les pertes thermiques, le vide est réalisé dans l'enceinte cryostatique délimitée par le boîtier 22. Ainsi, le transfert de chaleur par convection, des parties chaudes du cryostat vers le circuit de détection, est nul.

Par contre, il n'est pas prévu, dans le détecteur de la figure 1, de limiter les transferts de chaleur par conduction et par radiation. Or, ces flux de chaleur nuisent aux performances du détecteur et à l'efficacité du cryostat.

L'état de la technique est illustré par les documents US20110024162, US20140054081, US4118947 et US4926007.

### Résumé de l'invention

On constate qu'il existe un besoin de limiter les pertes thermiques dans un détecteur infrarouge, afin d'optimiser son refroidissement.

On tend à satisfaire ce besoin en prévoyant dans le détecteur infrarouge un circuit imprimé flexible avec une émissivité réduite tel que défini dans la revendication 1. Ce circuit imprimé flexible comprend des première et seconde extrémités, et une partie centrale flexible s'étendant entre les première et seconde extrémités. La partie centrale comporte des pistes électriquement conductrices, enrobées dans un matériau polymère, pour relier électriquement les première et seconde extrémités. En outre, elle est couverte au moins en partie par un écran thermique formé dans un matériau électriquement conducteur ayant une émissivité inférieure à celles du matériau polymère et des pistes électriquement conductrices.

Dans un mode de réalisation préférentiel, le matériau de la couche d'isolation thermique est avantageusement choisi parmi les métaux suivants : l'or, l'argent, le cuivre et le tungstène. L'invention vise également un détecteur infrarouge muni d'un tel circuit imprimé flexible. La première extrémité du circuit flexible est en liaison thermique avec une source froide du détecteur et la seconde extrémité est en liaison thermique avec une source chaude. Il en résulte un gradient de température dans la partie centrale flexible.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente un détecteur infrarouge selon l'art antérieur ;
- la figure 2 est une vue de dessus schématique d'un circuit imprimé flexible munie d'une couche d'isolation thermique selon l'invention ;
- la figure 3 représente, en vue de coupe selon l'axe A-A, le circuit imprimé flexible selon la figure 2.

### Description d'un mode de réalisation préféré de l'invention

Le circuit imprimé flexible 46 de la figure 1, appelé communément « circuit flex » (de l'anglais « flexible printed circuit board », flex-PCB), est majoritairement formé d'un film de matériau polymère, en général du polyimide. Il comprend des pistes métalliques noyées dans le film de polyimide. Ces pistes métalliques relient électriquement les deux connecteurs placés aux extrémités du circuit imprimé flexible.

Le circuit imprimé est soumis à une différence de température, puisqu'une de ses extrémités est fixée à la table froide (à l'intérieur du cryostat) et l'autre extrémité est fixée à la paroi du cryostat (en échange thermique avec l'extérieur). De plus, le métal (aluminium, cuivre) qui constitue les pistes du circuit est généralement un bon conducteur thermique. De fait, les pistes métalliques conduisent la chaleur d'un connecteur électrique à l'autre, et plus particulièrement de la paroi du cryostat vers la table froide du détecteur. Ce transfert de chaleur par conduction ne représente cependant qu'une petite partie des pertes thermiques.

La majeure partie des pertes thermiques est causée par un phénomène de radiation du circuit imprimé flexible. En effet, la surface du circuit imprimé flexible émet, comme tous les autres corps, un rayonnement électromagnétique quelle que soit sa température. Ce rayonnement électromagnétique est d'autant plus intense que la température du circuit est élevée. On peut aussi le qualifier de rayonnement thermique.

En plus de la température, la puissance rayonnée par le circuit imprimé flexible dépend de l'émissivité des matériaux qui composent sa surface. L'émissivité d'un matériau, notée ε, peut être définie comme étant le rapport entre l'énergie rayonnée par une surface et l'énergie du flux incident reçu par cette surface. Ainsi, plus l'émissivité du matériau est élevée, plus l'énergie rayonnée est importante.

Dans le cas d'un circuit flex classique à base de polyimide, le coefficient d'émissivité est élevé, environ égal à 0,7. La chaleur rayonnée par le circuit flex à l'intérieur du cryostat est donc significative.

Pour remédier à ces pertes thermiques par radiation, on propose de recouvrir au moins une partie du circuit imprimé flexible par une couche d'isolation thermique, ou écran thermique, en un matériau d'émissivité inférieure à celles du polyimide et des pistes métalliques. Ainsi, l'énergie thermique rayonnée par le flex dans l'enceinte cryostatique est diminuée par rapport à un flex classique dépourvu d'écran thermique.

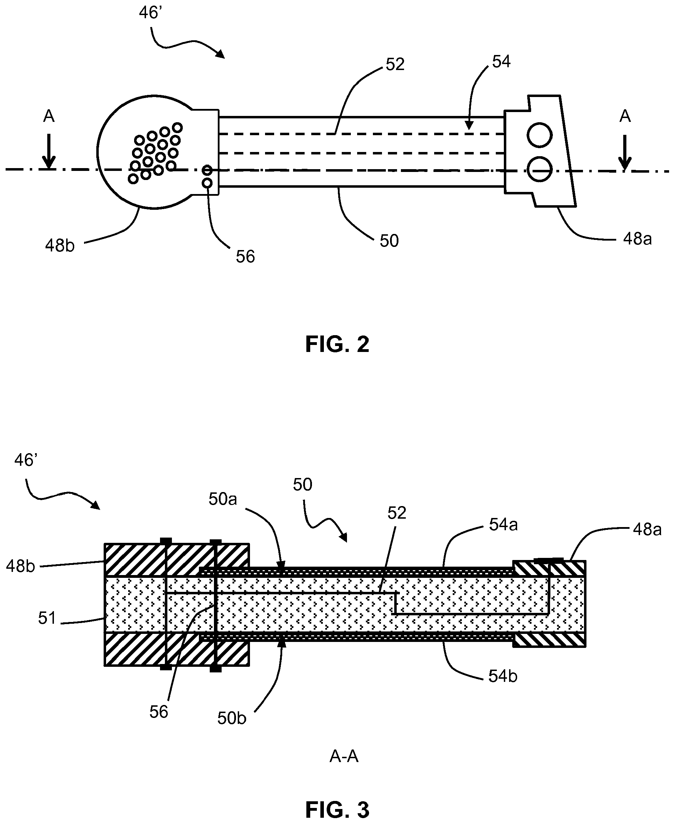

Les figures 2 et 3 représentent, respectivement en vue de dessus et en vue de coupe transversale, un circuit imprimé flexible 46' à faible émissivité.

Le circuit imprimé 46', de forme allongée, comprend deux connecteurs électriques 48a et 48b situés à des extrémités opposées du circuit imprimé et une partie centrale flexible 50, par exemple de forme rectangulaire, s'étendant entre les deux connecteurs 48a et 48b. Par « partie centrale flexible », on désigne un ou plusieurs matériaux empilés pouvant se courber d'un rayon de courbure inférieur à 20 mm.

Le circuit imprimé 46' comporte, au moins dans sa partie centrale 50, un film de polymère 51, par exemple du polyimide, et des pistes électriques 52 en métal enrobées par le matériau polymère. Les pistes 52 relient électriquement les deux connecteurs 48a et 48b.

Les connecteurs électriques 48a et 48b peuvent être rigides ou bien flexibles, comme le film de polymère 51. Ils peuvent en outre comporter des éléments de fixation mécanique, afin d'être montés sur les éléments du détecteur. Des pièces en métal, telles que des cales ou des renforts, peuvent être prévus à cet effet.

A titre d'exemple, le connecteur 48b des figures 2 et 3 comprend un ensemble de trous formés dans un circuit imprimé et qui se superposent à ceux formés dans le film de polymère 51. Le connecteur 48a comprend, plus simplement, des plots de connexion par soudure (« bonding »).

Le circuit imprimé 46' comprend également un écran thermique 54 recouvrant au moins une portion de la partie centrale 50. L'écran 54 est formé d'un matériau ayant un coefficient d'émissivité inférieur aux coefficients d'émissivité du polymère et des pistes électriques 52. Le coefficient d'émissivité de l'écran 54 est inférieur ou égal à 0,05.

Dans le mode de réalisation préférentiel des figures 2 et 3, la partie centrale flexible 50 comprend deux faces principales 50a et 50b, avantageusement parallèles (Fig. 3). L'écran thermique 54 couvre au moins l'une de ces faces. De préférence, chacune des faces 50a, 50b est entièrement recouverte d'une couche d'isolation thermique, respectivement 54a et 54b.

Le matériau de l'écran 54 (ou des écrans 54a et 54b) est électriquement conducteur. Ce matériau est avantageusement choisi parmi l'or, l'argent, le cuivre et le tungstène, qui font partie des matériaux de plus faible émissivité (émissivité valant respectivement entre 0,018 et 0,035, entre 0,02 et 0,032, entre 0,03 et 0,04).

Le dépôt d'un métal faiblement émissif comme l'or sur le circuit flex n'a pas été envisagé jusqu'à présent, car les métaux sont de bons conducteurs thermiques. Le dépôt d'une couche de métal aura donc pour conséquence d'augmenter le flux de chaleur par conduction, ce que l'on cherche à éviter. Toutefois, on constate que la diminution des radiations est plus importante que l'augmentation du phénomène de conduction. Les pertes thermiques sont donc, dans l'ensemble, réduites.

Ainsi, contre toute attente, il est possible de diminuer les pertes thermiques dans un détecteur infrarouge en déposant une couche en métal de faible épaisseur et de faible émissivité sur le circuit imprimé flexible, car la conduction thermique est un phénomène mineur devant le rayonnement thermique.

Le transfert thermique par conduction augmente avec l'épaisseur de l'écran thermique 54. Dans le circuit imprimé des figures 2 et 3, l'épaisseur de l'écran 54 est avantageusement choisie entre 50 nm et 200 nm. Cette plage d'épaisseurs permet d'obtenir un bon compromis entre les phénomènes de conduction et de radiation.

Par ailleurs, l'utilisation d'un matériau électriquement conducteur comme écran thermique permet de réduire le bruit électromagnétique dû à l'environnement dans lequel se situe le détecteur.

A titre d'exemple, les détecteurs infrarouges refroidis sont couramment employés dans des satellites, pour l'observation terrestre ou spatiale. Ils sont alors soumis à d'importants rayonnements électromagnétiques, dont le rayonnement solaire, qui font naître des charges électriques dans les pièces du détecteur. L'écran électriquement conducteur 54 permet d'évacuer ces charges électriques, réduisant ainsi leur impact sur la détection infrarouge. Pour cela, il peut être prévu dans le circuit imprimé flexible des figures 2 et 3 au moins un via d'interconnexion 56 entre l'écran 54 en métal et l'une des pistes métalliques 52 qui acheminent le courant.

Le circuit imprimé flexible 46' est tout aussi simple de fabrication et d'utilisation que les circuits imprimés flexibles de l'art antérieur. En effet, sa réalisation ne requiert que des procédés standards dans l'industrie des circuits PCB.

L'écran 54 est, de préférence, formé en déposant le matériau faiblement émissif sur le circuit imprimé flexible, par exemple par pulvérisation sous vide. Alternativement, l'écran 54 peut être formé d'une couche d'isolation simple, connue sous l'acronyme « SLI » (pour « Single Layer Insulation » en anglais) ou d'un empilement de plusieurs couches SLI (couche d'isolation multiple, MLI). Il est dans ce cas collé sur la surface en polymère du circuit imprimé, au moyen par exemple d'un adhésif.

Le circuit imprimé flexible 46' est notamment destiné à être intégré dans le cryostat d'un détecteur infrarouge refroidi, entre le circuit de détection du détecteur et la paroi du cryostat. Eventuellement, la paroi extérieure du cryostat porte une carte de proximité. Les signaux d'adressage du détecteur et les signaux issus de celui-ci transitent alors par les pistes électriques du circuit imprimé flexible, entre le circuit de détection et la carte de proximité.

Dans cette application privilégiée du circuit flex à faible émissivité, le connecteur 48a est connecté électriquement et mécaniquement à la table froide ou au circuit de lecture du détecteur infrarouge. Ainsi, une extrémité du circuit imprimé est en liaison thermique avec la source froide du détecteur. La source froide est, selon la température d'utilisation, un réservoir d'azote liquide, d'hélium liquide ou d'air liquide. Il peut également s'agir d'une machine à froid, par exemple un tube à gaz pulsé. De façon classique, la table froide sur laquelle repose le circuit de détection est en liaison thermique avec la source froide par l'intermédiaire d'un doigt froid. De préférence, la température de la source froide vaut 50 K environ.

L'extrémité opposée, qui porte le connecteur 48b, est en liaison thermique avec une source chaude, i.e. la paroi extérieure du cryostat et la carte de proximité, toutes deux à la température ambiante. Cette température ambiante est bien supérieure à la température de fonctionnement nominal du circuit de détection. Elle est, par exemple, égale à 300 K.

Enfin, le vide est créé dans le cryostat, afin d'annuler les transferts thermiques par convection.

## Revendications

1. Circuit imprimé flexible comprenant :
- des première seconde extrémités (48a, 48b) ; et
- une partie centrale flexible (50) s'étendant entre les première et seconde extrémités et comportant des pistes électriquement conductrices (52), enrobées dans un matériau polymère, pour relier électriquement les première et seconde extrémités ,
**caractérisé en ce que** la partie centrale flexible est couverte au moins en partie par un écran thermique (54) formé dans un matériau électriquement conducteur ayant une émissivité inférieure à celles du matériau polymère et des pistes électriquement conductrices, le matériau de l'écran thermique (54) ayant une émissivité inférieure à 0,05 et **en ce que** l'écran thermique (54) a une épaisseur comprise entre 50 et 200 nm.

2. Circuit imprimé flexible selon la revendication 1, dans lequel la partie centrale flexible (50) comprend deux faces principales (50a, 50b) recouvertes chacune d'un écran thermique (54a, 54b).

3. Circuit imprimé flexible selon l'une quelconque des revendications 1 ou 2, dans lequel le matériau de l'écran thermique (54) est choisi parmi l'or, l'argent, le cuivre et le tungstène.

4. Circuit imprimé flexible selon la revendication 2 ou 3, comprenant un via d'interconnexion électrique (56) entre l'une des pistes conductrices (52) et l'écran thermique (54).

5. Détecteur infrarouge comprenant une source chaude, une source froide et un circuit imprimé flexible selon l'une quelconque des revendications 1 à 4, dans lequel la première extrémité est en liaison thermique avec la source froide et la seconde extrémité est en liaison thermique avec la source chaude, d'où il résulte un gradient de température dans la partie centrale flexible.

6. Détecteur infrarouge selon la revendication 5, dans lequel le circuit imprimé flexible est disposé à l'intérieur d'une enceinte cryostatique sous vide.

## Patentansprüche

1. Flexible Leiterplatte, umfassend:
- ein erstes und ein zweites Ende (48a, 48b); und
- ein flexibler Mittelteil (50), der sich zwischen dem ersten und dem zweiten Ende erstreckt und von einem Polymermaterial umhüllte Leiterbahnen (52) aufweist, um das erste und das zweite Ende elektrisch zu verbinden,
**dadurch gekennzeichnet, dass** der flexible Mittelteil mindestens teilweise von einer Wärmeabschirmung (54) bedeckt ist, die in einem elektrisch leitenden Material ausgebildet ist, dessen Emissivität kleiner als die des Polymermaterials und der Leiterbahnen ist, wobei das Material der Wärmeabschirmung (54) eine Emissivität kleiner als 0,05 aufweist, und dadurch, dass die Wärmeabschirmung (54) eine Dicke zwischen 50 und 200 nm hat.

2. Flexible Leiterplatte nach Anspruch 1, wobei der flexible Mittelteil (50) zwei Hauptflächen (50a, 50b) umfasst, die jeweils von einer Wärmeabschirmung (54a, 54b) bedeckt sind.

3. Flexible Leiterplatte nach einem der Ansprüche 1 oder 2, wobei das Material der Wärmeabschirmung (54) aus Gold, Silber, Kupfer und Wolfram gewählt ist.

4. Flexible Leiterplatte nach Anspruch 2 oder 3, umfassend eine Durchkontaktierung (56) zwischen einer der Leiterbahnen (52) und der Wärmeabschirmung (54).

5. Infrarotdetektor, umfassend eine Wärmequelle, eine Kältequelle und eine flexible Leiterplatte nach einem der Ansprüche 1 bis 4, wobei das erste Ende mit der Kältequelle in thermischer Verbindung ist und das zweite Ende mit der Wärmequelle in thermischer Verbindung ist, wodurch sich im flexiblen Mittelteil ein Temperaturgradient ergibt.

6. Infrarotdetektor nach Anspruch 5, wobei die flexible Leiterplatte in einer kryostatischen Vakuumkammer angeordnet ist.

## Claims

1. Flexible printed circuit comprising:
- first and second ends (48a, 48b); and
- a flexible central portion (50) extending between the first and second ends and comprising electrically-conductive tracks (52), coated with a polymer material, to electrically connect the first and second ends,
**characterized in that** the flexible central portion is at least partly covered with a heat shield (54) made of an electrically conducting material having an emissivity smaller than those of the polymer material and of the electrically-conductive tracks, the material of the heat shield (54) having an emissivity smaller than 0.05 and **in that** the heat shield (54) has a thickness in the range from 50 to 200 nm.

2. Flexible printed circuit according to claim 1, wherein the flexible central portion (50) comprises two main surfaces (50a, 50b) each covered with a heat shield (54a, 54b).

3. Flexible printed circuit according to any of claims 1 or 2, wherein the material of the heat shield (54) is selected from among gold, silver, copper, and tungsten.

4. Flexible printed circuit according to claim 2 or 3, comprising an electric interconnection via (56) between one of the conductive tracks (52) and the heat shield (54).

5. Infrared detector comprising a hot source, a cold source, and a flexible printed circuit according to any of claims 1 to 4, wherein the first end is thermally connected to the cold source and the second end is thermally connected to the hot source, which results in a temperature gradient in the flexible central portion.

6. Infrared detector according to claim 5, wherein the flexible printed circuit is arranged inside of a vacuum cryostat chamber.
